# EUROPÄISCHE PATENTSCHRIFT

(11) **EP 1 216 509 B1**
(45) Veröffentlichungstag und Bekanntmachung des Hinweises auf die Patenterteilung: **07.03.2007**
(21) Anmeldenummer: 00975767.5
(22) Anmeldetag: 15.09.2000
(51) Int. Cl.: H03L 7/14, H03L 7/087

(54) **SCHALTUNGSANORDNUNG ZUM ERZEUGEN EINES ZU REFERENZTAKTSIGNALEN FREQUENZSYNCHRONEN TAKTSIGNALS**
CIRCUIT ARRANGEMENT FOR GENERATING A CLOCK-PULSE SIGNAL HAVING A FREQUENCY SYNCHRONOUS WITH A REFERENCE CLOCK-PULSE SIGNAL
CIRCUIT DE PRODUCTION D'UN SIGNAL DE SYNCHRONISATION SYNCHRONISE EN FREQUENCE AVEC DES SIGNAUX DE SYNCHRONISATION DE REFERENCE

(30) Priorität: 28.09.1999 DE 19946502
(43) Veröffentlichungstag der Anmeldung: 26.06.2002
(73) Patentinhaber: SIEMENS AKTIENGESELLSCHAFT, 80333 München (DE)
(72) Erfinder: ZWACK, Eduard, 82178 Puchheim (DE); HEITMANN, Jürgen, 82061 Neuried (DE)
(86) Internationale Anmeldenummer: PCT/DE2000/003219
(87) Internationale Veröffentlichungsnummer: WO 2001/024371

(56) Entgegenhaltungen:
- EP-A- 0 262 481
- WO-A-84/01069
- US-A- 5 950 115

## Beschreibung

In digitalen Kommunikationssystemen benötigen einzelne Kommunikationssystemkomponenten einen genauen Systemtakt zur Synchronisierung eines Austausches von Kommunikationsdaten. Üblicherweise werden einzelnen Kommunikationssystemkomponenten zu diesem Zweck hochgenaue Referenztaktsignale, z. B. über das öffentliche Netz, zugeführt. In der Regel bewirken die zugeführten Referenztaktsignale nicht direkt eine Taktsteuerung einer Kommunikationssystemkomponente, sondern werden auf einen Phasenregelkreis geführt, in dem Systemtaktsignale gebildet und an einzelne Baugruppen übermittelt werden.

Da eine störungsfreie Übermittlung eines externen Referenztaktsignals nicht jederzeit garantiert werden kann, ist in einer Kommunikationssystemkomponente häufig eine eigene hochstabile Referenztaktquelle vorgesehen, die bei Ausfall des externen Referenztaktes zur Stabilisierung des Taktgenerators über einen zweiten Phasenregelkreis verwendet wird.

Eine derartige Schaltungsanordnung ist beispielsweise aus der europäischen Patentanmeldung 0 262 481 bekannt. Diese Schaltungsanordnung enthält einen die externen Referenztaktsignale aufnehmenden Referenzempfangsteil, der mit einem ersten Eingang einer ersten Phasenvergleichseinrichtung verbunden ist. Der Ausgang der ersten Phasenvergleichseinrichtung ist über eine Integrationseinrichtung und ein Filter geführt, dessen Ausgang mit Hilfe eines Schaltelements mit einem nachgeschalteten spannungsgesteuerten Oszillator verbindbar ist. Die in dem spannungsgesteuerten Oszillator gebildeten frequenzsynchronen Taktsignale werden über dessen Ausgang sowohl an einen Ausgang der Schaltungsanordnung, als auch an einen zweiten Eingang, der ersten Phasenvergleichseinrichtung geführt.

Die bekannte Schaltungsanordnung enthält weiterhin eine hochstabile Referenztaktquelle, deren Ausgang mit einem ersten Eingang einer zweiten Phasenvergleichseinrichtung verbunden ist. Der zweite Eingang dieser zweiten Phasenvergleichseinrichtung ist ebenfalls mit dem Ausgang des spannungsgesteuerten Oszillators verbunden. Der Ausgang der zweiten Phasenvergleichseinrichtung ist mit Hilfe eines weiteren Schaltelements entweder mit einem zusätzlichen Filter oder mit einem Minuendeingang eines Subtrahiergliedes verbindbar. Der Ausgang des Subtrahiergliedes, an dessen Subtrahendeingang der Ausgang des zusätzlichen Filters geschaltet ist, ist über ein weiteres Filter mit einem weiteren Eingang des Schaltelements verbunden.

Die bekannte Schaltungsanordnung enthält somit zwei Phasenregelkreise, wobei der erste Phasenregelkreis durch die externen Referenztaktsignale und der zweite Phasenregelkreis durch die Referenztaktsignale der hochstabilen Referenztaktquelle gesteuert wird. Üblicherweise wird der spannungsgesteuerte Oszillator auf die zugeführten externen Referenztaktsignale synchronisiert. Bie Ausfall der externen Referenztaktsignale oder bei Überschreiten vorgegegebener Phasendifferenzen wird auf die hochstabile Referenztaktquelle umgeschaltet. In dem zusätzlichen Filter werden während der Synchronisierung durch die externen Referenztaktsignale die Abweichungen der frequenzsynchronen Taktsignale zu den Referenztaktsignalen der hochstabilen Referenztaktquelle aufgesammelt und Korrektureinstellinformationen gebildet. Diese werden nach Umschaltung auf die hochstabile Referenztaktquelle mit Hilfe des Subtrahiergliedes in die Bildung von Einstellinformationen für den spannungsgesteuerten Oszillator eingezogen.

Bei dieser Schaltungsanordnung besteht jedoch das Problem, daß zur Vermeidung einer zu langen Regelungsverzögerung die Frequenz der hochstabilen Referenztaktquelle verhältnismäßig hoch sein sollte. Eine hohe Taktfrequenz bedingt jedoch auch einen verhältnismäßig hohen Stromverbrauch, so daß eine solche Schaltungsanordnung für Batteriebetrieb wenig geeignet ist. Weiterhin sind bei einer solchen Schaltungsanordnung Schaltmittel vorzusehen, um periodisch auftretende Phasenüberläufe bei der zweiten Phasenvergleichseinrichtung zu erkennen. Als Phasenüberlauf wird dabei ein Überschreiten einer Phasendifferenz von 360 Grad bezeichnet. Solche Phasenüberläufe treten periodisch auf, wenn die Frequenz der Referenztaktquelle und die zum externen Referenztaktsignal synchronisierte Frequenz des spannungsgesteuerten Oszillators gegebenenfalls nach einem jeweiligen Durchgang durch einen Frequenzteiler, voneinander systematisch abweichen.

Es ist Aufgabe der vorliegenden Erfindung, eine Schaltungsanordnung zum Erzeugen eines zu Referenztaktsignalen frequenzsynchronen Taktsignals anzugeben, die eine verbesserte Regelcharakteristik, insbesondere bei Zuführung eines Referenztaktsignals mit verhältnismäßig niedriger Taktfrequenz, aufweist.

Gelöst wird diese Aufgabe durch eine Schaltungsanordnung mit den Merkmalen des Patentanspruchs 1.

Die erfindungsgemäße Schaltungsanordnung weist einen Oszillator auf, dessen Taktfrequenz in einer ersten Betriebsart der Schaltungsanordnung mittels eines eine erste Phasenvergleichseinrichtung umfassenden, ersten Phasenregelkreises mit einem zugeführten, ersten Referenztaktsignal synchronisiert wird. Weiterhin ist ein Phasenstellglied und eine zweite Phasenvergleichseinrichtung vorgesehen, mittes derer in der ersten Betriebsart eine Abweichung eines zugeführten, zweiten Referenztaktsignals zum frequenzsynchronen Taktsignal des Oszillators erfasst wird und eine Phasenkorrekturinformation gebildet wird. In einer zweiten Betriebsart der Schaltungsanordnung, z.B. bei Ausfall des ersten Referenztaktsignals, wird der Oszillator nicht mehr anhand des ersten Referenztaktsignals synchronisiert, sondern anhand des zweiten Referenztaktsignals. Eine solche zweite Betriebsart wird häufig auch als "Hold-Over-Modus" bezeichnet. In die Phasenregelung wird dabei die in der ersten Betriebsart gebildete Phasenkorrekturinformation einbezogen. Dies erfolgt dadurch, daß in das Taktsignal des Oszillators vor einem Phasenvergleich mit dem zweiten Referenztaktsignal, Taktphasen abhängig von der Phasenkorrekturinformation durch ein Phasenstellglied ein- oder ausgefügt werden.

Durch dieses Korrigieren der Oszillatorphase bzw. Oszillatorfrequenz vor dem Phasenvergleich mit dem zweiten Referenztaktsignal können bei einer systematischen Abweichung des zum ersten Referenztaktsignal frequenzsynchronen Oszillatortaktsignals zum zweiten Referenztaktsignal zyklisch auftretende Phasenüberläufe beim Phasenvergleich auf einfache Weise vermieden werden.

Ein Vorteil der erfindungsgemäßen Schaltungsanordnung besteht in einer sehr guten Regelungscharakteristik und in kurzen Regelungszeitkonstanten, die insbesondere auch bei einem verhältnismäßig niederfrequenten, zweiten Referenztaktsignal gewährleistet sind. Eine Erzeugnung von niederfrequenten Referenztaktsignalen erfordert im allgemeinen weniger Leistung als eine Erzeugung von höherfrequenten Referenztaktsignalen, so daß sich die erfindungsgemäße Schaltungsanordnung in Verbindung mit einem niederfrequenten Referenztaktgenerator auch gut für einen Batteriebetrieb eignet. Die gute Regelcharakteristik ist eine Folge davon, daß die Phasenkorrektur durch das Phasenstellglied auf das Taktsignal des Oszillators angewandt wird. Da das Taktsignal des Oszillators meist wesentlich höherfrequenter als das zweite Referenztaktsignal ist, kann durch Aus- oder Einfügen einzelner Taktphasen in das Taktsignal des Oszillators die Frequenz dieses Taktsignals vor dem Phasenvergleich sehr fein geregelt werden. Insbesondere wird dadurch nur ein sehr geringes Phasen- und Impulszittern verursacht.

Ein weiterer Vorteil der erfindungsgemäßen Schaltungsanordnung besteht darin, daß zu Ihrer Realisierung kein Prozessor erforderlich ist. Stattdessen kann die Schaltungsanordnung z.B. mittels eines kostengünstigen ASIC-Bausteins (Application Specific Integrated Circuit) realisiert werden.

Vorteilhafte Ausführungsformen und Weiterbildungen der Erfindung sind in den abhängigen Ansprüchen angegeben.

Der Ausgang der ersten Phasenvergleichseinrichtung kann an den Frequenzregeleingang des Oszillators über ein Schaltelement, wie z. B. ein Transistor , ein logisches Gatter oder eine Multiplexeinrichtung, angeschlossen sein. Dieses Schaltelement kann so angesteuert werden, daß es bei der ersten Betriebsart der Schaltungsanordnung geschlossen und bei der zweiten Betriebsart offen ist.

Vor dem Frequenzregeleingang des Oszillators kann weiterhin ein Filter, wie z. B. ein einfaches Tiefpassfilter oder ein sogenanntes P-, PI- oder PID-Filter, zum Integrieren von dem Oszillator zugeleiteten Signalen zur Frequenzregelung geschaltet sein. Häufig kann auch der Frequenzregeleingang des Oszillators selbst eine solche Filterfunktion übernehmen.

Weiterhin kann ein Speicher vorgesehen sein, in dem die in der ersten Betriebsart gebildete Phasenkorrekturinformation gespeichert bleibt, solange sich die Schaltungsanordnung in der zweiten Betriebsart befindet. In der zweiten Betriebsart wird das Ein- und Ausfügen von Taktphasen im Phasenstellglied dann abhängig von der gespeicherten Phasenkorrekturinformation gesteuert.

Um zwei verschiedene Taktsignale mittels einer Phasenvergleichseinrichtung vergleichen zu können, ist es in der Regel erforderlich, daß die zu vergleichenden Taktsignale die gleiche Sollfrequenz haben. Zum Vergleichen von Taktsignalen unterschiedlicher Sollfrequenz können diese Taktsignale jeweils über einen Frequenzteiler der Phasenvergleichseinrichtung zugeführt werden. Der Teilerfaktor eines jeweiligen Frequenzteilers ist dabei so zu bemessen, daß die an den Eingängen der Phasenvergleichseinrichtung anliegenden, geteilten Sollfrequenzen gleich sind.

Nach einer vorteilhaften Weiterbildung der Erfindung kann eine Detektoreinrichtung vorgesehen sein, mit der erkannt werden kann, ob das erste Referenztaktsignal vorliegt oder nicht. Ein Ausgang der Detektoreinrichtung kann mit einem oder mehreren Schaltelementen zum Steuern und/oder Umschalten der Betriebsart verbunden sein.

Gemäß einer vorteilhaften Ausführungsform der Erfindung kann die Regeleinrichtung einen Aufwärts-/Abwährtszähler aufweisen, dessen Zählrichtung vom Ausgangssignal der zweiten Phasenvergleichseinrichtung abhängt. Der Aufwärts-/Abwährtszähler kann beispielsweise so angesteuert sein, daß sein Zählerstand zu vorgegebenen Zeitpunkten, z. B. jeweils bei den positiven oder negativen Flanken des zweiten Referenztaktsignals, je nachdem ob die festgestellte Phasendifferenz positiv oder negativ ist, entweder inkrementiert oder dekrementiert wird. Bei Phasengleichheit kann der Zählerstand gleich bleiben.

Weiterhin kann eine Phasenstellgliedsteuerung mit einem Zählregister vorgesehen sein, das mit dem Zählerstand des Aufwärts-/Abwährtszählers als Zählvorgabe zu laden ist. Das Zählregister kann dabei z. B. in einem durch ein Taktsignal vorgegebenen Rhythmus ausgehend von der Zählvorgabe weitergezählt werden, um bei Erreichen einer vorgegebenen Zählmarke ein Ein- oder Ausfügen einer Taktphase im Phasenstellglied zu veranlassen.

Das Zählregister kann weiterhin in einen ersten Registerteil für höherwertige Bits und einen zweiten Registerteil für niederwertige Bits aufgeteilt sein, wobei eine Zählfrequenz, mit der der zweite Registerteil weitergezählt wird, durch den Inhalt des ersten Registerteils bestimmt ist. Durch diese funktionale Trennung der Registerteile läßt sich ein sehr großer Regelbereich auch bei geringer Länge des Zählregisters bzw. des Aufwärts-/Abwährtszählers erzielen. Dabei erfolgt die Regelung um so genauer, je geringer der Wert der höherwertigen, die Zählfrequenz bestimmenden Bits der Zählvorgabe ist, d. h. je weniger die von der zweiten Phasenvergleichseinrichtung zu vergleichenden Taktsignale voneinander abweichen.

Gemäß einer weiteren vorteilhaften Weiterbildung der Erfindung kann ein weiteres, durch die Regeleinrichtung gesteuertes Phasenstellglied zum Ableiten eines weiteren frequentsynchronen Taktsignals aus dem zweiten Referenztaktsignal vorgesehen sein. Auf diese Weise kann beispielsweise ein frequenzsynchrones Taktsignal für eine Uhrenanwendung bereitgestellt werden.

Nach einer weiteren Ausführungsvariante der Erfindung kann ein ein Vorliegen des zweiten Referenztaktsignals anzeigender Ausgang einer Detektoreinrichtung mit einem Alarmgeber zum Auslösen eines Alarmsignals bei Nichtvorliegen des zweiten Referenztaktsignals verbunden sein.

Gemäß einer weiteren Ausführungsvariante kann ein ein Vorliegen des Taktsignals des Oszillators anzeigender Ausgang einer Detektoreinrichtung mit einem Alarmgeber zum Auslösen eines Alarmsignals bei Nichtvorliegen des Taktsignals verbunden sein.

Ein Ausführungsbeispiel der Erfindung wird nachfolgend anhand der Zeichnung näher erläutert.

Dabei zeigen,
- FIG 1: eine erfindungsgemäße Schaltungsanordnung in schematischer Darstellung und
- FIG 2: eine grafische Veranschaulichung von Phasenbeziehungen von Taktsignalen.

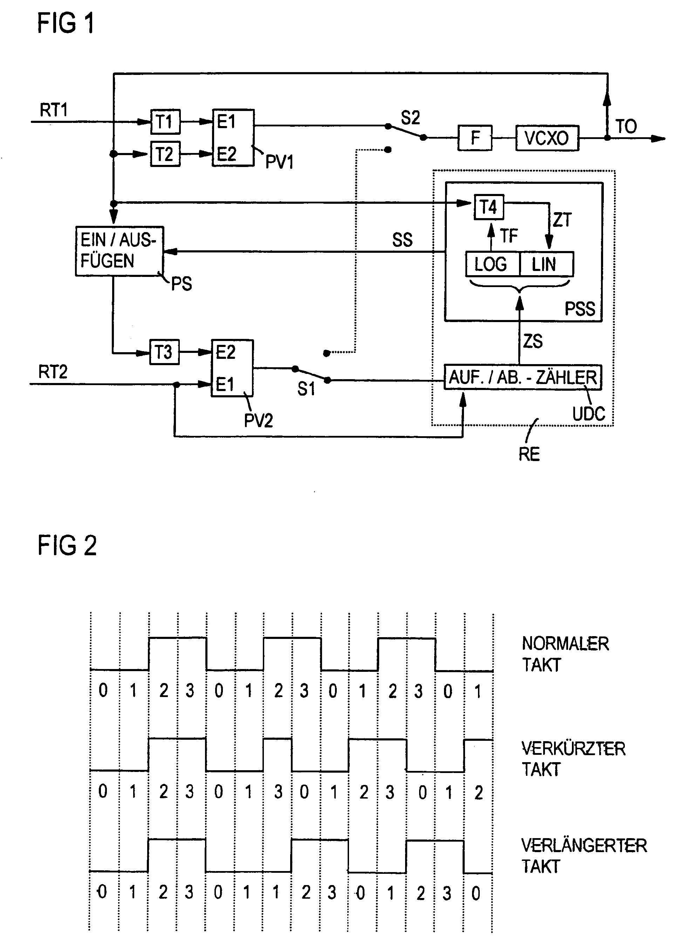

Figur 1 zeigt eine Schaltungsanordnung zum Erzeugen eines zu zugeführten Referenztaktsignalen RT1 und RT2 frequenzsynchronen Taktsignals TO in schematischer Darstellung. Die Schaltungsanordnung weist einen ersten Phasenregelkreis auf, der eine erste Phasenvergleichseinrichtung PV1, einen Filter F sowie einen spannungsgesteuerten Oszillator, einen sogenannten VCXO (Voltage Controlled X-tal Oscillator) umfasst. Der Ausgang der Phasenvergleichseinrichtung PV1 ist über ein Schaltelement S2 in einer ersten Betriebsart der Schaltungsanordnung mit einem Filter F und über dieses mit einem Frequenzregeleingang des Oszillators VCXO verbunden, der das zu synchronisierende Taktsignal TO bildet. Das Filter F dient zum Integrieren von dem Oszillator VCXO zugeführten Frequenzregelungssignalen und kann beispielsweise als Tiefpassfilter oder als sogenanntes P-, PI-, oder PID-Filter realisiert sein.

In der ersten Betriebsart ist das Taktsignal TO mit dem ersten Referenztaktsignal RT1 zu synchronisieren. Ein solches erstes Referenztaktsignal RT1 wird zur Synchronisierung von Kommunikationseinrichtungen häufig aus Netztaktsignalen, aus vom öffentlichen Kommunikationsnetz übermittelten Signalen oder aus drahtlos von einem Zeitinformationssender empfangenen Signalen abgeleitet. Das erste Referenztaktsignal RT1 wird über einen Frequenzteiler T1 einem ersten Eingang E1, der ersten Phasenvergleichseinrichtung PV1 zugeführt. Ebenso wird das Taktsignal TO des Oszillators VCXO über einen Frequenzteiler T2 einem zweiten Eingang E2 der ersten Phasenvergleichseinrichtung PV1 zugeleitet. Die Teilungsfaktoren der Frequenzteiler T1 und T2 sind dabei so bemessen, daß die jeweils geteilten Sollfrequenzen des Taktsignals TO und des ersten Referenztaktsignals RT1 jeweils gleich sind.

Als weitere Funktionskomponenten weist die Schaltungsanordnung ein Phasenstellglied PS zum Ein- und Ausfügen von Taktphasen in das Taktsignal TO, eine zweite Phasenvergleichseinrichtung PV2, sowie eine Regeleinrichtung RE auf. Die genannten Funktionskomponenten dienen in der ersten Betriebsart der Schaltungsanordnung dazu, eine Abweichung des zum ersten Referenztaktsignal RT1 frequenzsynchronen Taktsignals TO zum zweiten Referenztaktsignal RT2 zu erfassen. Das zweite Referenztaktsignal RT2 wird dazu einem ersten Eingang E1 der zweiten Phasenvergleichseinrichtung PV2 zugeführt. Das zweite Referenztaktsignal RT2 kann dabei z. B. von einem temperaturkompensierten Oszillator, einem sogenannten TCXO (Temperature Compensated X-tal Oscillator) erzeugt werden. Für das vorliegende Ausführungsbeispiel sei angenommen, daß das zweite Referenztaktsignal RT2 eine anwendungstypische Frequenz von 32768 Hz hat. Die Verwendung einer solchen verhältnismäßig niedrigen Frequenz hat den Vorteil, daß zur Erzeugung des zweiten Referenztaktsignals RT2 handelsübliche TCXOs verwendet werden können, die einen Stromverbrauch von nur wenigen Mikroampere haben. Damit eignet sich die erfindungsgemäße Schaltungsanordnung in Verbindung mit einem verhältnismäßig niederfrequenten TCXO als zweite Referenztaktquelle auch gut für Batteriebetrieb.

Zum Phasenvergleich mit dem zweiten Referenztaktsignal RT2 wird das Taktsignal TO des Oszillators VCXO über das Phasenstellglied PS und einen Frequenzteiler T3 zum Anpassen der Oszillatorsollfrequenz an die Frequenz des Referenztaktsignals RT2, einem zweiten Eingang E2 der zweiten Phasenvergleichseinrichtung PV2 zugeleitet. Bei einer typischen Oszillatorsollfrequenz von z. B. 16,384 Mhz ist zur Anpassung an die Frequenz von 32768 Hz des zweiten Referenztaktsignals RT2 ein Frequenzteiler T3 mit Teilerfaktor 500 vorzusehen. Eine derartig hohe Oszillatorfrequenz erlaubt durch Ein- und Ausfügen von Taktphasen eine besonders feine Regelung.

Das Ausgangssignal der zweiten Phasenvergleichseinrichtung PV2 wird über ein Schaltelement S1 in der ersten Betriebsart einem Aufwärts-/Abwärtszähler UDC der Regeleinrichtung RE zugeleitet und bestimmt dessen Zählrichtung. Die Zählfrequenz des Aufwärts-/Abwärtszählers UDC wird durch das diesemebenfalls zugeleitete zweite Referenztaktsignal RT2 vorgegeben. Beispielsweise kann bei jeder Phasenflanke des zweiten Referenztaktsignals RT2, die der entsprechenden Phasenflanke des geteilten Taktsignals TO vorauseilt, der Aufwärts-/Abwärtszähler UDC inkrementiert und bei einem Nacheilen entsprechend dekrementiert werden. Bei annähernder Phasengleichheit wird der Aufwärts-/Abwärtszähler UDC angehalten. Als annähernde Phasengleichheit kann in diesem Sinne gelten, wenn die jeweils gemessene Phasendifferenz innerhalb eines vorgegebenen Intervalls liegt. Ein jeweiliger Zählerstand ZS des Aufwärts-/Abwärtszählers UDC repräsentiert eine akkumulierte Phasenkorrekturinformation, die eine Abweichung des zum ersten Referenztaktsignal RT1 frequenzsynchronen Taktsignals TO zum zweiten Referenztaktsignal RT2 und damit eine Abweichung zwischen erstem und zweitem Referenztaktsignal beschreibt.

Die Regeleinrichtung RE umfasst außerdem eine Phasenstellgliedsteuerung PSS mit einem Zählregister, das in einen ersten Registerteil LOG für höherwertige Bits und einen zweiten Registerteil LIN für niederwertige Bits aufgeteilt ist. Die Phasenstellgliedsteuerung PSS enthält weiterhin einen Frequenzteiler T4, dem das Taktsignal TO des Oszillators VCXO vor Durchlaufen des Phasenstellgliedes PS zugeführt wird. Der Teilerfaktor TF des Frequenzteilers T4 wird durch den Inhalt des Registerteils LOG des Zählregisters bestimmt. Die geteilte Ausgangsfrequenz des Frequenzteilers T4 kann damit in weiten Grenzen, z. B. typischerweise zwischen 4 Hz und 4096 Hz variiert werden. Das vom Frequenzteiler T4 geteilte Taktsignal TO gibt einen Zähltakt ZT vor, mit dem der Registerteil LIN des Zählregisters weitergezählt wird.

Im Rahmen der Steuerung des Phasenstellgliedes PS wird der Zählerstand ZS des Aufwärts-/Abwärtszählers UDC als Zählvorgabe in das Zählregister der Phasenstellgliedsteuerung PSS übertragen. Die in den Registerteil LOG übertragenen höherwertigen Bits des Zählerstandes ZS legen damit einen aktuellen Teilerfaktor TF fest, während mit den in den Registerteil LIN übertragenen, niederwertigen Bits des Zählerstandes ZS ein neuer Startwert für die Zählung vorgegeben wird. Nach dem Übertragen des Zählerstandes ZS wird der Registerteil LIN im Rhythmus des Zähltaktes ZT bis zu einer vorgegebenen Zählmarke weitergezählt. Bei Erreichen dieser Zählmarke wird durch die Phasenstellgliedsteuerung PSS ein Steuersignal SS gebildet, das dem Phasenstellglied PS zugeleitet wird und dort ein Ausfügen oder ein Einfügen einer Taktphase in das Taktsignal TO des Oszillators VCXO veranlaßt. Abhängig von einem Vorzeichenbit des Zählerstandes ZS wird dabei entschieden, ob ein Steuersignal zum Einfügen oder ein Steuersignal zum Ausfügen einer Taktphase gebildet wird. Weiterhin wird bei Erreichen der vorgegebenen Zählmarke der Inhalt des Zählregisters durch Nachladen eines aktuellen Zählerstandes ZS vom Aufwärts-/Abwärtszähler UDC erneuert und somit ein erneuter Zähldurchlauf des Zählregisters initiiert.

In einer zweiten Betriebsart der erfindungsgemäße Schaltungsanordnung, in die z.B. bei Ausfall des ersten Referenztaktsignals RT1 automatisch umgeschaltet werden kann, wird das Taktsignal TO anhand des zweiten Referenztaktsignals RT2 unter Einbeziehung der in der ersten Betriebsart gebildeten Phasenkorrekturinformation ZS synchronisiert. Dabei soll die Synchronität zum nicht mehr verwendeten, ersten Referenztaktsignal RT1 möglichst genau erhalten bleiben.

In die zweite Betriebsart wird durch Umschalten der Schaltelemente S1 und S2 geschaltet. Mit dem Schaltelement S1 wird dazu der Ausgang der zweiten Phasenvergleichseinrichtung PV2 vom Aufwärts-/Abwärtszähler UDC getrennt und stattdessen über eine durch eine gepunktete Linie angedeutete Verbindung mit einem Eingang des Schaltelements S2 verbunden. Dieser Eingang wird durch Umschalten des Schaltelements S2 über das Filter F an den Frequenzregeleingang des Oszillators VCXO gekoppelt. Durch das Umschalten des Schaltelements S2 wird die bisherige Verbindung zwischen dem Ausgang der Phasenvergleichseinrichtung PV1 und dem Filter F unterbrochen. Durch das beschriebene Umschalten der Schaltelemente S1 und S2 bildet sich ein zweiter Phasenregelkreis aus, der den Oszillator VCXO das Phasenstellglied PS, die zweite Phasenvergleichseinrichtung PV2 und das Filter F umfaßt. Das Taktsignal TO wird damit anhand des zweiten Referenztaktsignals RT2 synchronisiert.

Nach Trennung der zweiten Phasenvergleichseinrichtung PV2 vom Aufwärts-/Abwärtszähler UDC wird dieser angehalten. Sein letzter Zählerstand ZS bleibt dabei als Phasenkorrekturinformation gespeichert und wird wie in der ersten Betriebsart zum Nachladen des Zählregisters der Phasenstellgliedsteuerung PSS verwendet. Das Ein- bzw. Ausfügen von Taktphasen wird von der Phasenstellgliedsteuerung PSS also nach Maßgabe des in der zweiten Betriebsart konstanten, letzten Zählerstandes ZS des Aufwärts-/Abwärtszählers UDC fortgesetzt. Die Phasenregelung im zweiten Phasenregelkreis wird dadurch um die zuletzt festgestellte Abweichung des zweiten Referenztaktsignals RT2 vom ersten Referenztaktsignal RT1 korrigiert, so daß das Taktsignals TO mit hoher Genauigkeit zum nicht mehr vorliegenden ersten Referenztaktsignal RT1 synchron bleibt.

FIG 2 veranschaulicht die durch ein Aus- und Einfügen von Taktphasen durch das Phasenstellglied bedingte Veränderung des zeitlichen Verlaufs des Taktsignals TO. Während die oberste Kurve dabei den zeitlichen Verlauf eines durch das Phasenstellglied PS unveränderten Taktsignals darstellt, zeigen die mittlere Kurve ein Taktsignal mit einer entnommenen Taktphase und die untere Kurve ein Taktsignal mit einer eingefügten Taktphase.

Im vorliegenden Ausführungsbeispiel ist das Phasenstellglied PS auf besonders einfache Weise mit Hilfe eines 2-Bit-Zählers realisiert. Dieser durchläuft während einer Taktperiode des Taktsignals TO die Zählstufen 0,1,2 und 3. Das Ausgangssignal des Phasenstellgliedes PS wird vom Zustand des höherwertigen Bits des 2-Bit-Zählers abgeleitet, d.h. während der Zählstufen 0 und 1 ist das Ausgangssignal auf Null und während der Zählstufen 2 und 3 auf Eins. Die jeweiligen Zählstufen des Zählers sind jeweils unterhalb der dargestellten Taktsignalkurven angegeben.

Eine Taktphase wird nun ausgefügt, indem eine Zählstufe des 2-Bit-Zählers, auf Veranlassung des Steuersignals SS, übersprungen wird. Damit springt die Phase der nachfolgenden Takte um 90 Grad vorwärts. Analog dazu wird eine Taktphase eingefügt, indem ein Zählimpuls, der ansonsten ein Weiterzählen des 2-Bit-Zählers veranlassen würde unterdrückt wird, so daß der 2-Bit-Zähler erst wieder beim nächsten Zählimpuls weitergezählt wird. Die Phase nachfolgender Takte verschiebt sich dadurch um 90 Grad rückwärts.

## Patentansprüche

1. Schaltungsanordnung zum Erzeugen eines zu Referenztaktsignalen (RT1, RT2) frequenzsynchronen Taktsignals (TO), mit
a) einem das frequenzsynchrone Taktsignal (TO) bildenden Oszillator (VCXO), dessen Taktfrequenz über einen Frequenzregeleingang regelbar ist,
b) einer ersten Phasenvergleichseinrichtung (PV1) mit einem ersten Eingang (E1) zum Ankoppeln eines ersten Referenztaktsignals (RT1), einem zweiten Eingang (E2), dem das Taktsignal (TO) des Oszillators (VCXO) zugeleitet wird, sowie einem Ausgang, der an den Frequenzregeleingang des Oszillators (VCXO) geführt ist, und
c) einer zweiten Phasenvergleichseinrichtung (PV2) mit einem ersten Eingang (E1) zum Ankoppeln eines zweiten Referenztaktsignals (RT2) und einem Ausgang, der über ein Schaltelement (S1) betriebsartabhängig an den Frequenzregeleingang des Oszillators (VCXO) koppelbar ist, **gekennzeichnet durch**
d) ein Phasenstellglied (PS) zum Ein- und Ausfügen von Taktphasen, über das das Taktsignal (TO) des Oszillators (VCXO) einem zweiten Eingang (E2) der zweiten Phasenvergleichseinrichtung (PV2) zugeleitet wird, wobei ein Ein- und Ausfügen von Taktphasen über einen Steuereingang des Phasenstellgliedes (PS) steuerbar ist, und
e) eine Regeleinrichtung (RE), die über ein Schaltelement (S1) betriebsartabhängig mit dem Ausgang der zweiten Phasenvergleichseinrichtung (PV2) verbindbar ist, um abhängig von deren Ausgangssignal eine Phasenkorrekturinformation (ZS) zu bilden, und die mit dem Steuereingang des Phasenstellgliedes (PS) verbunden ist, um abhängig von der gebildeten Phasenkorrekturinformation (ZS) ein Ein- und Ausfügen von Taktphasen zu steuern.

2. Schaltungsanordnung nach Anspruch 1,
**dadurch gekennzeichnet,**
**daß** der Ausgang der ersten Phasenvergleichseinrichtung (PV1) an den Frequenzregeleingang des Oszillators (VCXO) über ein Schaltelement (S2) geführt ist, durch das der Ausgang der ersten Phasenvergleichseinrichtung (PV1) und der Frequenzregeleingang des Oszillators (VCXO) betriebsartabhängig verbindbar und trennbar sind.

3. Schaltungsanordnung nach Anspruch 1 oder 2,
**gekennzeichnet durch**
ein vor den Frequenzregeleingang des Oszillators (VCXO) geschaltetes Filter (F) zum Integrieren von dem Oszillator (VCXO) zugeleiteten Signalen zur Frequenzregelung.

4. Schaltungsanordnung nach einem der vorhergehenden Ansprüche,
**gekennzeichnet durch**
einen Speicher zum betriebsartabhängigen Speichern der Phasenkorrekturinformation (ZS).

5. Schaltungsanordnung nach einem der vorhergehenden Ansprüche,
**dadurch gekennzeichnet,**
**daß** mindestens einem Eingang (E1, E2) mindestens einer Phasenvergleichseinrichtung (PV1, PV2) ein Frequenzteiler (T1, T2, T3) vorgeschaltet ist.

6. Schaltungsanordnung nach einem der vorhergehenden Ansprüche,
**dadurch gekennzeichnet,**
**daß** ein ein Vorliegen des ersten Referenztaktsignals (RT1) anzeigender Ausgang einer Detektoreinrichtung mit einem Schaltelement (S1, S2) zur Betriebsartensteuerung verbunden ist.

7. Schaltungsanordnung nach einem der vorhergehenden Ansprüche,
**dadurch gekennzeichnet,**
**daß** ein ein Vorliegen des zweiten Referenztaktsignals (RT2) anzeigender Ausgang einer Detektoreinrichtung mit
einem Alarmgeber zum Auslösen eines Alarmsignals bei Nichtvorliegen des zweiten Referenztaktsignals (RT2) verbunden ist.

8. Schaltungsanordnung nach einem der vorhergehenden Ansprüche,
**dadurch gekennzeichnet,**
**daß** ein ein Vorliegen des Taktsignals (TO) des Oszillators (VCXO) anzeigender Ausgang einer Detektoreinrichtung mit einem Alarmgeber zum Auslösen eines Alarmsignals bei Nichtvorliegen des Taktsignals (TO) verbunden ist.

9. Schaltungsanordnung nach einem der vorhergehenden Ansprüche,
**dadurch gekennzeichnet,**
**daß** die Regeleinrichtung (RE) einen Aufwärts/Abwärts-Zähler (UDC) aufweist, dessen Zählrichtung vom Ausgangsignal der zweiten Phasenvergleichseinrichtung (PV2) abhängt und dessen Zählerstand (ZS) die Phasenkorrekturinformation repräsentiert.

10. Schaltungsanordnung nach Anspruch 9,
**dadurch gekennzeichnet,**
**daß** die Regeleinrichtung (RE) eine Phasenstellgliedsteuerung (PSS) aufweist, mit einem mit dem Zählerstand (ZS) des Aufwärts/Abwärts-Zählers (UDC) als Zählvorgabe zu ladenden Zählregister (LOG, LIN), das bei Erreichen einer vorgegebenen Zählmarke ein Ein- oder Ausfügen einer Taktphase im Phasenstellglied (PS) veranlaßt.

11. Schaltungsanordnung nach Anspruch 10,
**dadurch gekennzeichnet,**
**daß** das Zählregister in einen ersten Registerteil (LOG) für höherwertige Bits und einen zweiten Registerteil (LIN) für niederwertige Bits aufgeteilt ist, und
eine Zählfrequenz, mit der der zweite Registerteil (LIN) durchgezählt wird, durch den Inhalt des ersten Registerteils (LOG) bestimmt ist.

12. Schaltungsanordnung nach einem der vorhergehenden Ansprüche,
**gekennzeichnet durch**
ein weiteres, **durch** die Regeleinrichtung (RE) gesteuertes Phasenstellglied zum Ableiten eines weiteren frequenzsynchronen Taktsignals aus dem zweiten Referenztaktsignal (RT2).

## Claims

1. Circuit arrangement for producing a clock signal (TO) whose frequency is synchronous with that of reference clock signals (RT1, RT2), having
a) an oscillator (VCXO) which forms the synchronous-frequency clock signal (TO) and whose clock frequency can be controlled via a frequency control input,
b) a first phase comparison device (PV1) having a first input (E1) for coupling a first reference clock signal (RT1), a second input (E2), to which the clock signal (TO) from the oscillator (VCXO) is supplied, and an output which is routed to the frequency control input of the oscillator (VCXO), and
c) a second phase comparison device (PV2) having a first input (E1) for coupling a second reference clock signal (RT2) and an output which can be coupled to the frequency control input of the oscillator (VCXO) via a switching element (S1) on the basis of operating mode,
**characterized by**
d) a phase control element (PS) for inserting and removing clock phases which is used to supply the clock signal (TO) from the oscillator (VCXO) to a second input (E2) of the second phase comparison device (PV2), with insertion and removal of clock phases being able to be controlled via a control input of the phase control element (PS), and
e) a regulating device (RE) which can be connected to the output of the second phase comparison device (PV2) via a switching element (S1) on the basis of operating mode in order to form phase correction information (ZS) on the basis of the second phase comparison device's output signal and which is connected to the control input of the phase control element (PS) in order to control insertion and removal of clock phases on the basis of the phase correction information (ZS) formed.

2. Circuit arrangement according to claim 1,
**characterized**
**in that** the output of the first phase comparison device (PV1) is routed to the frequency control input of the oscillator (VCXO) via a switching element (S2) which can connect and isolate the output of the first phase comparison device (PV1) and the frequency control input of the oscillator (VCXO) on the basis of operating mode.

3. Circuit arrangement according to claim 1 or 2,
**characterized by**
a filter (F) connected upstream of the frequency control input of the oscillator (VCXO) for the purposes of integrating frequency control signals supplied to the oscillator (VCXO).

4. Circuit arrangement according to one of the preceding claims,
**characterized by**
a memory for storing the phase correction information (ZS) on the basis of operating mode.

5. Circuit arrangement according to one of the preceding claims,
**characterized**
**in that** a frequency divider (T1, T2, T3) is connected upstream of at least one input (E1, E2) of at least one phase comparison device (PV1, PV2).

6. Circuit arrangement according to one of the preceding claims,
**characterized**
**in that** an output of a detector device which indicates when the first reference clock signal (RT1) is present is connected to a switching element (S1, S2) for controlling the operating mode.

7. Circuit arrangement according to one of the preceding claims,
**characterized**
**in that** an output of a detector device which indicates when the second reference clock signal (RT2) is present is connected to an alarm transmitter for triggering an alarm signal when the second reference clock signal (RT2) is not present.

8. Circuit arrangement according to one of the preceding claims,
**characterized**
**in that** an output of a detector device which indicates when the clock signal (TO) from the oscillator (VCXO) is present is connected to an alarm transmitter for triggering an alarm signal when the clock signal (TO) is not present.

9. Circuit arrangement according to one of the preceding claims,
**characterized**
**in that** the regulating device (RE) has an up/down counter (UDC) whose counting direction is dependent on the output signal from the second phase comparison device (PV2) and whose counter reading (ZS) represents the phase correction information.

10. Circuit arrangement according to claim 9,
**characterized**
**in that** the regulating device (RE) has a phase control element controller (PSS) having a counting register (LOG, LIN) which can be loaded with the counter reading (ZS) from the up/down counter (UDC) as a counting preset and prompts insertion or removal of a clock phase in the phase control element (PS) when a prescribed counting marker is reached.

11. Circuit arrangement according to claim 10,
**characterized**
**in that** the counting register is split into a first register part (LOG) for more significant bits and a second register part (LIN) for less significant bits, and
a counting frequency used to count through the second register part (LIN) is determined by the content of the first register part (LOG).

12. Circuit arrangement according to one of the preceding claims,
**characterized by**
a further phase control element, controlled by the regulating device (RE), for deriving a further synchronous-frequency clock signal from the second reference clock signal (RT2).

## Revendications

1. Circuit destiné à générer un signal de synchronisation (TO) synchronisé en fréquence avec des signaux de synchronisation de référence (RT1, RT2), comprenant
a) un oscillateur (VCXO) formant le signal de synchronisation (TO) synchronisé en fréquence, dont la fréquence de synchronisation est réglable par l'intermédiaire d'une entrée de réglage de fréquence,
b) un premier dispositif de comparaison des phases (PV1) doté d'une première entrée (E1) destinée à coupler un premier signal de synchronisation de référence (RT1), une deuxième entrée (E2) à laquelle est amené le signal de synchronisation (TO) de l'oscillateur (VCXO), ainsi qu'une sortie qui est menée à l'entrée de réglage de fréquence de l'oscillateur (VCXO), et
c) un deuxième dispositif de comparaison des phases (PV2) doté d'une première entrée (E1) destinée à coupler un deuxième signal de synchronisation de référence (RT2) et une sortie qui peut être couplée à l'entrée de réglage de fréquence de l'oscillateur (VCXO) par l'intermédiaire d'un élément de commutation (S1), en fonction du mode de fonctionnement,
**caractérisé par**
d) un organe de réglage de phase (PS) destiné à insérer et retirer des phases de synchronisation, par l'intermédiaire duquel le signal de synchronisation (TO) de l'oscillateur (VCXO) est amené à une deuxième entrée (E2) du deuxième dispositif de comparaison des phases (PV2), une insertion et un retrait de phases de synchronisation étant commandables par l'intermédiaire d'une entrée de commande de l'organe de réglage de phase (PS), et
e) un dispositif de réglage (RE) qui est raccordable à la sortie du deuxième dispositif de comparaison des phases (PV2) par l'intermédiaire d'un élément de commutation (S1) en fonction du mode de fonctionnement, afin, en fonction du signal de sortie de ce dispositif de comparaison des phases, de former une information de correction de phase (ZS), et qui est raccordé à l'entrée de commande de l'organe de réglage de phase (PS) afin, en fonction de l'information de correction de phase (ZS) formée, de commander une insertion et un retrait de phases de synchronisation.

2. Circuit selon la revendication 1,
**caractérisé en ce**
**que** la sortie du premier dispositif de comparaison des phases (PV1) est menée à l'entrée de réglage de fréquence de l'oscillateur (VCXO) par l'intermédiaire d'un élément de commutation (S2) au moyen duquel la sortie du premier dispositif de comparaison des phases (PV1) et la sortie de réglage de fréquence de l'oscillateur (VCXO) sont raccordables et séparables en fonction du mode de fonctionnement.

3. Circuit selon la revendication 1 ou 2,
**caractérisé par**
un filtre (F) commuté en amont de l'entrée de réglage de fréquence de l'oscillateur (VCXO), destiné à insérer des signaux amenés par l'oscillateur (VCXO) pour le réglage de fréquence.

4. Circuit selon l'une quelconque des revendications précédentes,
**caractérisé par**
une mémoire destinée à la mémorisation, dépendante du mode de fonctionnement, de l'information de correction de phase (ZS).

5. Circuit selon l'une quelconque des revendications précédentes,
**caractérisé en ce**
**qu'**un diviseur de fréquence (T1, T2, T3) est installé en amont d'au moins une entrée (E1, E2) d'au moins un dispositif de comparaison des phases (PV1, PV2).

6. Circuit selon l'une quelconque des revendications précédentes,
**caractérisé en ce**
**qu'**une sortie d'un dispositif détecteur, indiquant une présence du premier signal de synchronisation de référence (RT1), est raccordée à un élément de commutation (S1, S2) pour la commande du mode de fonctionnement.

7. Circuit selon l'une quelconque des revendications précédentes,
**caractérisé en ce**
**qu'**une sortie d'un dispositif détecteur, indiquant une présence du deuxième signal de synchronisation de référence (RT2), est raccordée à un dispositif d'alarme destiné à déclencher un signal d'alarme en cas de non-présence du deuxième signal de synchronisation de référence (RT2).

8. Circuit selon l'une quelconque des revendications précédentes,
**caractérisé en ce**
**qu'**une sortie d'un dispositif détecteur, indiquant une présence du signal de synchronisation (TO) de l'oscillateur (VCXO), est raccordée à un dispositif d'alarme destiné à déclencher un signal d'alarme en cas de non-présence du signal de synchronisation (TO).

9. Circuit selon l'une quelconque des revendications précédentes,
**caractérisé en ce**
**que** le dispositif de réglage (RE) présente un compteur comptant/décomptant (UDC) dont le sens de comptage dépend du signal de sortie du deuxième dispositif de comparaison des phases (PV2)
et
dont la position de compteur (ZS) représente l'information de correction de phase.

10. Circuit selon la revendication 9,
**caractérisé en ce**
**que** le dispositif de réglage (RE) présente une commande de l'organe de réglage de phase (PSS), comprenant un enregistreur compteur (LOG, LIN) à charger avec la position de compteur (ZS) du compteur comptant/décomptant (UDC), comme indication de comptage, cet enregistreur compteur, lorsqu'une marque de comptage prédéfinie est atteinte, causant l'insertion ou le retrait d'une phase de synchronisation dans l'organe de réglage de phase (PS).

11. Circuit selon la revendication 10,
**caractérisé en ce**
**que** l'enregistreur compteur est divisé en une première partie d'enregistreur (LOG) pour des bits de valeur plus élevée et en une deuxième partie d'enregistreur (LIN) pour des bits de valeur plus basse, et en ce qu'une fréquence de comptage, au moyen de laquelle la deuxième partie d'enregistreur (LIN) est comptée, détermine le contenu de la première partie d'enregistreur (LOG).

12. Circuit selon l'une quelconque des revendications précédentes,
**caractérisé par**
un autre organe de réglage de phase commandé par le dispositif de réglage (RE), destiné à dériver un autre signal de synchronisation, synchronisé en fréquence, à partir du deuxième signal de synchronisation de référence (RT2).
